# EUROPEAN PATENT SPECIFICATION

(11) **EP 1 890 335 B1**
(45) Date of publication and mention of the grant of the patent: **06.10.2010**
(21) Application number: 06017058.6
(22) Date of filing: 16.08.2006
(51) Int. Cl.: H01L 29/78, H01L 21/336, H01L 29/06, H01L 29/423, H01L 29/08

(54) **Method of making a lateral DMOS device**
Verfahren zur Herstellung einer lateralen DMOS-Anordnung
Méthode de fabrication d'un dispositif DMOS latéral

(43) Date of publication of application: 20.02.2008
(73) Proprietor: austriamicrosystems AG, 8141 Unterpremstätten (AT)
(72) Inventor: Park, Jong Mun, 8010 Graz (AT); Minixhofer, Rainer, 8141 Unterpremstätten (AT); Knaipp, Martin, 8141 Unterpremstätten (AT)
(74) Representative: Epping - Hermann - Fischer

(56) References cited:
- US-A1- 2003 001 216
- US-A1- 2005 112 822

## Description

This invention concerns a method of producing lateral diffused MOS transistor for high-voltage applications.

High-voltage LDMOS (lateral double-diffused MOS) transistors are widely used for output devices in smart power applications. For a scaling-down of the process technology below dimensions of 0.25 µm, shallow trench isolations (STI) have to be introduced in the HV-LDMOS transistors. However, STI causes reliability problems, especially problems arising from the generation of large numbers of hot carriers and stress related leakage currents in the vicinity of the edges of the STI regions. During high-voltage operations, a strong electric field occurs at the edges of the shallow trench isolation. Due to the focusing of the electric field, electrons and holes generated by impact ionization can be sufficiently accelerated to gain enough kinetic energy to be injected into the dielectric material, which is typically oxide. The electrons and holes having a large kinetic energy, called hot carriers, interact with the dielectric material and can generate defects, especially at the interface between the semiconductor material and the insulator, typically silicon and silicon dioxide, and in the silicon dioxide, thus causing a shift in the electric characteristics of the performance of the semiconductor device. Therefore, the generation of large numbers of hot carriers in the vicinity of the shallow trench isolations is detrimental to the long-term reliability of the device, and these undesirable effects are preferably avoided.

Furthermore, carriers that are generated mainly at the STI edges are injected from the drift region into the body region and cause a turn-on of the parasitic bipolar transistor formed by the sequence of doped layers having alternating types of conductivity. A strong electric field in the vicinity of the STI edges has therefore to be avoided as much as possible in order to prevent a device degradation due to the induced hot carriers and to improve the electrical safe operation area (SOA).

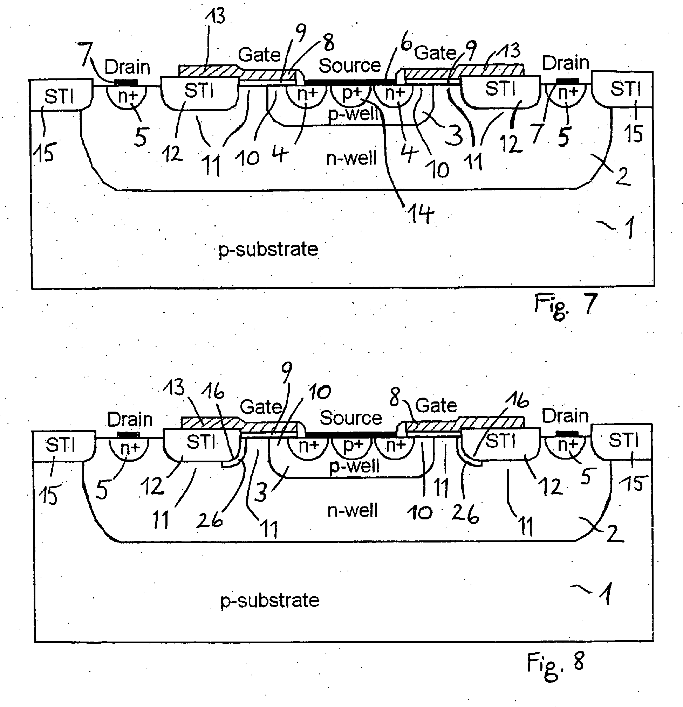

The appended figure 7 shows a cross-section of a conventional high-voltage lateral diffused MOS device. The signs of the conductivity types (p and n conductivity) are inserted giving an example of an n-channel transistor. The conductivities are inverted in the case of a p-channel transistor. The present invention concerns either type of transistor. The signs of the conductivity are therefore only exemplary and do not restrict the scope of the invention. A substrate 1 of semiconductor material, which may have a basic doping or may be intrinsically doped, is provided with a first well 2, in this example of n-type conductivity, and a second well 3 of the opposite conductivity type. The second well 3 is located within the first well 2, and both wells are disposed at an upper main surface of the substrate 1. The second well 3 is provided with a source region 4 having the conductivity type of the first well 2. The source region is preferably highly doped. The arrangement of the components of this device is preferably symmetrical around a vertical axis; and the two areas of the cross-section of the source region 4 in figure 7 show two portions of a single source region. A drain region 5 having the same type of conductivity as the source region 4 is arranged at the surface of the first well 2, surrounding the source region 4 and disposed concentrically with respect to the source region 4. Instead of a circular arrangement, the upper areas of the source and drain regions 4, 5 can be elliptic or similarly elongated in one direction. For the sake of simplicity, the geometrical shape is assumed to be a stripe in the following description.

The space between the source region 4 and the drain region 5 is interrupted by an isolation region 12 formed by a shallow trench isolation, which forms an electrically insulating region. Between the source region 4 and the isolation region 12, the upper surface of the second well 3 forms the channel region 10 of the transistor. It is controlled by a gate electrode 8, which is arranged above the channel region 10 and electrically insulated from the semiconductor material by a thin gate dielectric 9. Between the channel region 10 and the drain region 5, the first well 2 provides a drift region 11 for the charge carriers moving from source to drain during the operation of the device. Preferably, a field plate 13 is disposed above the isolation region 12 and electrically connected to the gate electrode 8. A source contact 6 is applied to the source region 4. The source contact 6 is preferably also connected to the second well 3 via a highly doped contact region 14 of the same conductivity type as the second well 3. The drain region 5 is supplied with a drain contact 7. For better isolation between adjacent devices, an optional outer isolation region 15 can be introduced in the device, which is preferably also formed by a shallow trench isolation.

Figure 8 shows an improved embodiment of the device according to figure 7, which additionally comprises an edge region 26 under the inner edge of the isolation region 12. This conventional edge region 26 covers the edge 16 of the isolation region 12 and has the same conductivity type as the first well 2, but is doped with a higher concentration of the doping atoms. This embodiment aims at improving the on-state performance of the transistor by the introduction of extra n-type dopant at the STI edge in the drift region 11. However, especially this favorable approach may give rise to the generation of an extremely large number of hot carriers by further focusing the electric field to the STI edge. Therefore the difficulty of avoiding the electric field near the STI edge while at the same time maintaining the desired blocking voltage cannot be removed by this modification of the device, which is nevertheless an improvement in other respects.

US 2003/0001216 A1 discloses a semiconductor component including a substrate, a channel region in the substrate, a gate electrode, a drain region, a source region, the source region being located in a well of a first doping type located in a well of a second doping type, a drift region located in the well of the second doping type, an isolation region arranged at the surface of the substrate above the drift region and having an edge facing the drift region and the source region, and an electrically floating region at the edge of the isolation region as well as a method of producing such a component.

US 2005/0112822 A1 D2 discloses a semiconductor circuit including a DMOS transistor comprising an isolation region and an edge region being contiguous with an edge of the isolation region and having the same sign of conductivity as the drift region, but a higher doping concentration.

It is an object of this invention to present a method for producing a lateral diffused MOS device that avoids the aforementioned problems.

This and further objects are achieved by the method of claim 1 and the variants of the method according to the dependent claims.

The lateral diffused MOS device is provided with an additional implanted edge region at the inner edge of the isolation region facing the drift region and the source region. The edge region has a conductivity type opposite to the conductivity type of the first well. In this way, the occurrence of a strong electric field at the edge of the isolation region and an acceleration of charge carriers up to an injection of hot carriers into the insulating material are avoided.

The edge region is produced by a further implantation step through a small mask opening in a layer of a material which fills the shallow trench and is selectively etchable with respect to the semiconductor material. A further edge region can be provided under the first edge region on the side opposite to the shallow trench isolation, in order to improve the drifting path of the charge carriers moving from source to drain through the drift region. The further edge region is provided with a conductivity type that is the same as the conductivity type of the first well and the drift region. An unfavorable partial bar of the drift region caused by the first edge region is thus compensated.

A more detailed description of examples of the invention will now be given in connection with the appended figures.
FIG. 1 shows a cross-section of an LDMOS produced by a first embodiment of the inventive method.
FIG. 2 shows a cross-section of an LDMOS produced by a second embodiment of the inventive method..
FIG. 3 shows a cross-section of a first intermediate product of a preferred production method.
FIG. 4 shows a cross-section according to FIG. 3 of a further intermediate product after the formation of shallow trenches.
FIG. 5 shows a cross-section according to FIG. 4 of a further intermediate product after the formation of an edge region.
FIG. 6 shows a cross-section according to FIG. 5 for an alternative embodiment.
FIG. 7 shows a cross-section of a conventional LDMOS device.
FIG. 8 shows a cross-section of an improved conventional LDMOS device.

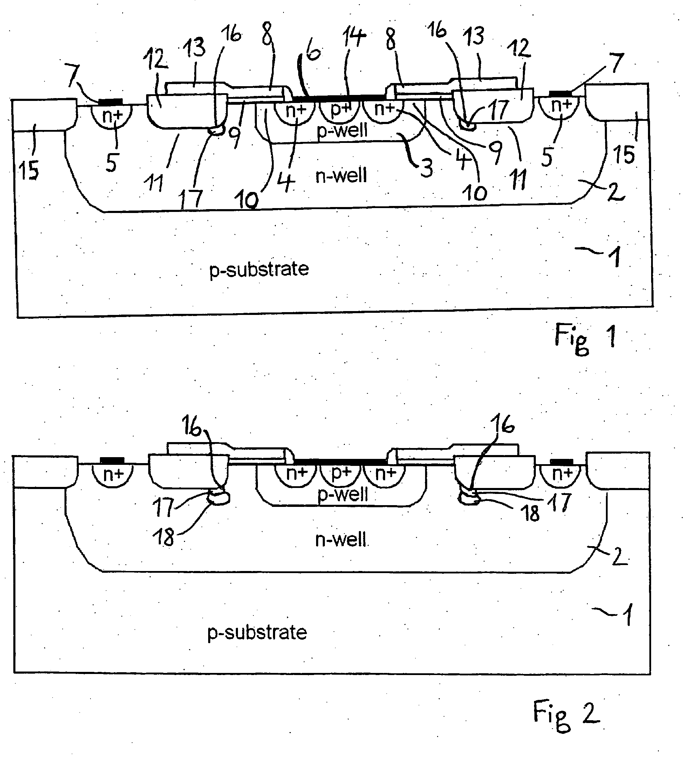

FIG. 1 shows a cross-section of an LDMOS device produced by an embodiment of the inventive method. The principal structure is similar to the one already explained in connection with FIG. 7 and 8. Like reference numerals designate the corresponding device components, which are listed once more for the sake of completeness. The substrate 1 of semiconductor material is provided with a first well 2, a second well 3 disposed within the first well, a source region 4, a drain region 5, a source contact 6, a drain contact 7, a gate electrode 8, a gate dielectric 9, a channel region 10 located in the second well 3, a drift region 11 located between the channel region 10 and the drain region 5, and an isolation region 12 formed by a shallow trench isolation, preferably furthermore a field plate 13, a contact region 14 provided for the second well 3, and an outer isolation region 15. The edge region 17 is arranged under an inner edge 16 of the isolation region 12. The lateral and vertical extensions of the edge region 17 can be adapted to optimize the performance of the device. The edge region 17 is arranged in the vicinity of the edge 16 of the isolation region 12 and preferably covers the edge 16. The edge region 17 is preferably arranged to be contiguous with the edge 16 and in contact with the insulating material. Thus, the volume occupied by the edge region 17 is excluded from the drift region 11. Since the drifting path of the charge carriers moving from source to drain is partially barred by the edge region 17, a further edge region can be provided as a compensation.

FIG. 2 shows an LDMOS obtained by a second embodiment that is provided with a further edge region 18 to compensate for the effect of the first edge region 17. Whereas the first edge region 17 is provided with a conductivity type that is opposite to the conductivity of the first well 2 and the drift region 11, the further edge region 18 is provided with the conductivity type of the drift region. The further edge region 18 is preferably doped with a higher concentration of doping atoms than the basic doping of the first well 2. The other components of the LDMOS according to FIG. 2 correspond to the components of the LDMOS of FIG. 1 and need not be specified any further.

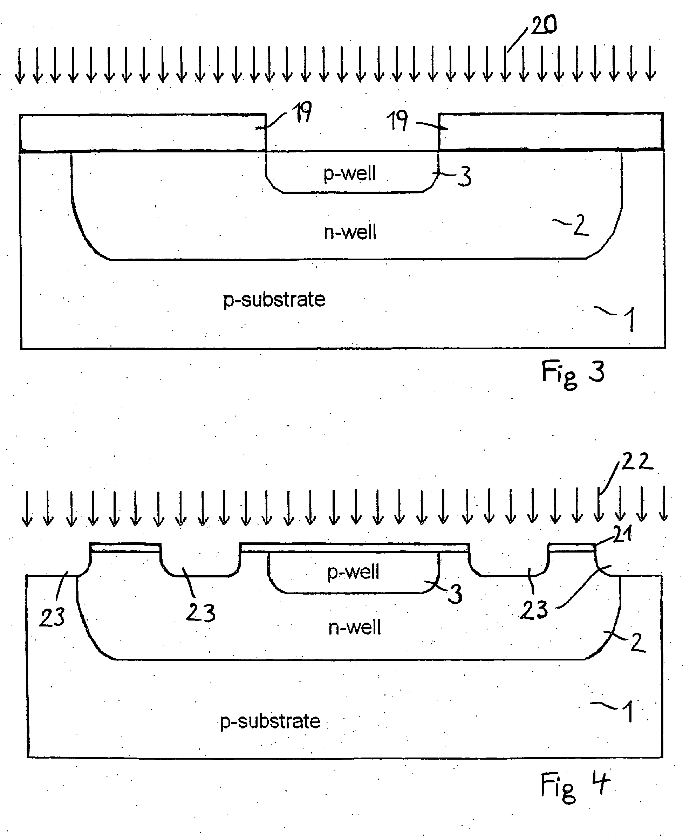

A preferred method of production of this device is described in conjunction with FIGs. 3 to 6. FIG. 3 shows a cross-section of an intermediate product comprising a substrate 1, a first well 2 and a second well 3 for the method step of the implantation 20 of the second well 3, indicated by arrows. The implantation is performed by means of a first mask 19, which covers the area surrounding the region provided for the second well 3. In this example, the substrate 1 is provided with a basic p-doping. Instead, it may be intrinsically doped, or the sign of the conductivities may be interchanged.

FIG. 4 shows a further intermediate product for the step of the etching 22 of the shallow trenches 23 by means of a second mask 21. The shallow trenches 23 are preferably formed to a minor depth as compared to the n-well, which is indicated in an exemplary manner in FIG. 4. Although the depth of the inner shallow trench 23 can be varied according to the embodiment that has to be produced, the inner shallow trench 23 does not intercept the first well vertically. This allows the arrangement of source and drain on opposite sides of the inner shallow trench. The drift region is provided under the inner shallow trench. The outer shallow trench is optional and provided as an isolation from the adjacent device.

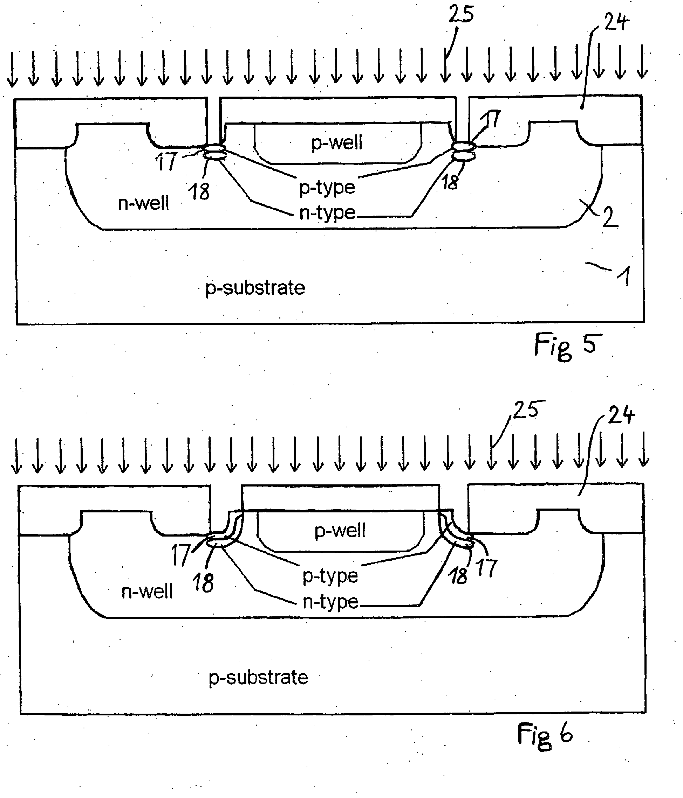

FIG. 5 shows a further intermediate product in a cross-section according to FIG. 4. After the shallow trenches 23 have been filled with a material that is selectively etchable with respect to the semiconductor material, a third mask 24 is formed by the formation of openings in the material in the areas where the edge regions are to be arranged. Then a further implantation 25 is performed to implant the dopant provided for the edge region 17, as well as, preferably, a second dopant provided for the opposite type of conductivity and provided for the further edge region 18, implanted slightly deeper than the dopant provided for the first edge region 17. The signs of conductivity are indicated in FIG. 5 for the example of an n-channel transistor. As has already been mentioned, the conductivity types can be interchanged. The openings in the third mask 24 are then filled, preferably with the same material that has already been applied to fill the shallow trenches. Alternatively, the material of the third mask 24 can be completely removed and substituted with a dielectric material that is provided for the formation of shallow trench isolations. In any case, the material that is first applied to fill the trenches is selected to be selectively etchable with respect to the semiconductor material so that the openings can be formed without attacking the semiconductor material, in order to avoid a deterioration of the drift region. It is also possible to leave a thin layer of the material of the third mask 24 on the semiconductor surface, thus slightly screening the subsequent implantation 25.

FIG. 6 shows the intermediate product according to FIG. 5 for a variant of the production method. In this embodiment, the openings in the third mask 24 are formed broader in order to uncover marginal areas of the upper substrate surface adjacent to the shallow trench. In this manner, the edge region 17 and, if provided, the further edge region 18 are formed to cover the whole edge of the isolation region 12.

Since the edge region 17 is surrounded by dielectric material and semiconductor material of opposite type of conductivity, the edge region 17 is kept floating, without being directly connected to any of the applied voltages. The device performance on-state is improved by the modification of the drift region by the further edge region 18. By the introduction of the floating region at the edge of the STI, the electric field at the STI edge can effectively be reduced. An extra doping of the conductivity type of the second well 2 compensates for an increase of on-resistance due to the floating edge region. In the structure obtained by the inventive method, the peak of the electric field is shifted from the edge of the STI at the side facing the gate to the drain side of the STI. Thus, the generation of hot carriers is suppressed or at least essentially reduced at the edge of the STI facing the gate without degrading the on-state current handling capability of the transistor. This is a significant improvement of the LDMOS device, especially as the blocking voltages of the conventional device is essentially maintained.

List of reference numerals
- 1: substrate
- 2: first well
- 3: second well
- 4: source region
- 5: drain region
- 6: source contact
- 7: drain contact
- 8: gate electrode
- 9: gate dielectric
- 10: channel region
- 11: drift region
- 12: isolation region (STI, shallow trench isolation)
- 13: field plate
- 14: contact region
- 15: outer isolation region
- 16: edge of the isolation region
- 17: edge region
- 18: further edge region
- 19: first mask
- 20: implantation
- 21: second mask
- 22: etching
- 23: shallow trench
- 24: third mask
- 25: further implantation
- 26: conventional diffused edge region

## Claims

1. Method for production of a lateral diffused MOS device, comprising:
- providing a substrate (1) of semiconductor material at a main surface with a first well (2) of a first conductivity type and with a second well (3) of an opposite second conductivity type arranged within the first well (2),
- etching a shallow trench (23) in a surface area of the first well (2),
- filling the shallow trench (23) with a material that is selectively etchable with respect to the semiconductor material,
- forming an opening in the material filling the shallow trench (23) above a bottom edge of the trench that faces the second well (3), and,
- using the remaining material as a mask (24), performing an implantation (25) of a dopant provided for the second conductivity type.

2. Method according to claim 1, wherein
the shallow trench (23) is filled with a material that is suitable to form a shallow trench isolation.

3. Method according to claim 1 or 2, further comprising:
performing an implantation of a dopant provided for the first conductivity type slightly deeper than the implantation of the dopant provided for the second conductivity type.

4. Method according to one of claims 1 to 3, further comprising
performing a subsequent further implantation to form regions of source and drain of the first conductivity type.

## Patentansprüche

1. Verfahren zur Herstellung eines seitlich diffundierten MOS Bauelements, umfassend:
- Bereitstellen eines Substrates (1) aus Halbleitermaterial an einer Hauptoberfläche mit einer ersten Wanne (2) eines ersten Leitfähigkeitstyp und einer innerhalb der ersten Wanne (2) angeordneten zweiten Wanne (3) eines entgegengesetzten zweiten Leitfähigkeitstyp,
- Ätzen eines flachen Grabens (23) in einem Oberflächenbereich der ersten Wanne (2),
- Füllen des flachen Grabens (23) mit einem Material, das im Hinblick auf das Halbleitermaterial selektiv geätzt werden kann,
- Ausbilden einer Öffnung in dem den flachen Graben (23) füllenden Material über einem der zweiten Wanne (3) zugewandten, unteren Rand des Grabens, und
- unter Verwendung des restlichen Materials als Maske (24) Durchführen einer Implantation (25) eines für den zweiten Leitfähigkeitstyp vorgesehenen Dotierstoffes.

2. Verfahren nach Anspruch 1, wobei
der flache Graben (23) mit einem Material gefüllt wird, das für die Bildung einer flachen Grabenisolation geeignet ist.

3. Verfahren nach Anspruch 1 oder 2, weiter umfassend:
Durchführen einer Implantation eines für den ersten Leitfähigkeitstyp vorgesehenen Dotierstoffes, die geringfügig tiefer als die Implantation des für den zweiten Leitfähigkeitstyp vorgesehenen Dotierstoffes ist.

4. Verfahren nach einem der Ansprüche 1 bis 3, weiter umfassend
Durchführen einer nachfolgenden, weiteren Implantation zur Ausbildung von Source- und Draingebieten des ersten Leitfähigkeitstyp.

## Revendications

1. Procédé de production d'un appareil MOS à diffusion latérale, comportant :
- la fourniture d'un substrat (1) de matériau semi-conducteur sur une surface principale avec un premier caisson (2) d'un premier type de conductivité et avec un deuxième caisson (3) d'un deuxième type de conductivité opposé disposé à l'intérieur du premier caisson (2),
- la gravure d'une tranchée peu profonde (23) dans une zone de surface du premier caisson (2),
- le remplissage de la tranchée peu profonde (23) avec un matériau gravable sélectivement par rapport au matériau semi-conducteur,
- la formation d'un orifice dans le matériau remplissant la tranchée peu profonde (23) au-dessus d'un bord inférieur de la tranchée situé en face du deuxième caisson (3), et
- l'utilisation du matériau restant comme masque (24), réalisant une implantation (25) d'un dopant prévu pour le deuxième type de conductivité.

2. Procédé selon la revendication 1, où
la tranchée peu profonde (23) est remplie d'un matériau qui est apte à former une isolation en tranchée peu profonde.

3. Procédé selon la revendication 1 ou 2, comportant en outre :
la réalisation d'une implantation d'un dopant prévu pour le premier type de conductivité à un niveau légèrement plus profond que l'implantation du dopant prévu pour le deuxième type de conductivité.

4. Procédé selon l'une des revendications 1 à 3, comportant en outre :
la réalisation d'une autre implantation subséquente pour former des régions de source et de drain du premier type de conductivité.
